(19) **Europäisches Patentamt**
**European Patent Office**
**Office européen des brevets**

(11) **EP 3 107 210 B1**

(12) **EUROPEAN PATENT SPECIFICATION**

(45) Date of publication and mention
of the grant of the patent:
**04.12.2019 Bulletin 2019/49**

(51) Int Cl.:
*H03F 3/45* *(2006.01)*   *H03F 3/30* *(2006.01)*
*G11C 5/14* *(2006.01)*   *G11C 16/12* *(2006.01)*
*H03M 1/66* *(2006.01)*

(21) Application number: **15200607.8**

(22) Date of filing: **16.12.2015**

(54) **AMPLIFIER CIRCUIT WITH STATIC CONSUMPTION CONTROL AND CORRESPONDING CONTROL METHOD**

VERSTÄRKERSCHALTUNG MIT STATISCHER VERBRAUCHSSTEUERUNG UND ENTSPRECHENDES STEUERUNGSVERFAHREN

CIRCUIT D'AMPLIFICATEUR À COMMANDE DE CONSOMMATION STATIQUE ET PROCÉDÉ DE COMMANDE CORRESPONDANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.06.2015 IT UB20151473**

(43) Date of publication of application:
**21.12.2016 Bulletin 2016/51**

(73) Proprietor: **STMicroelectronics S.r.l.**
**20864 Agrate Brianza (MB) (IT)**

(72) Inventors:
• **CONTE, Antonino**
**95030 TREMESTIERI ETNEO (IT)**
• **DI MARTINO, Alberto Jose'**
**95046 PATAGONIA (IT)**

(74) Representative: **Nannucci, Lorenzo et al**
**Studio Torta S.p.A.**
**Via Viotti, 9**
**10121 Torino (IT)**

(56) References cited:
**EP-A1- 2 299 576**    **US-A1- 2006 197 513**
**US-B1- 6 433 521**

## Description

The present invention relates to an amplifier circuit with static consumption control and to a corresponding control method. In particular, the following discussion will refer, without this implying any loss of generality, to use of this amplifier circuit in a digital-to-analog converter device, for example for a nonvolatile memory of the flash type.

As it is known, digital-to-analog converters are used in flash memories for generating the biasing voltages required during reading, programming, and verify operations for the terminals of the memory cells each time addressed.

In particular, it is known that the aforesaid memory operations are rather complex and that the voltages required may vary considerably, a wide range of voltage levels with values even very distant from one another being thus required. For instance, an erase operation may require sending to the gate terminal of an addressed memory cell a voltage ramp, having steps of variation of 0.3 V between a minimum voltage of 4 V up to a maximum voltage of 10 V, or else, a so-called "soft programming" operation may require sending to the gate terminal of an addressed memory cell a voltage ramp, having steps of variation of 0.125 V between a minimum voltage of 2.5 V up to a maximum voltage of 7 V.

Furthermore, rapid transitions are generally required between the various voltage levels generated, both in charging and discharging conditions; the capacitive load conditions are also very variable, for example, they may vary between a minimum load of 2-3 pF up to a maximum load of 400 pF.

The digital-to-analog converter, and in particular a corresponding amplifier circuit that generates the biasing voltages required during the various memory operations, is consequently to meet stringent requirements from the standpoint of electrical performance.

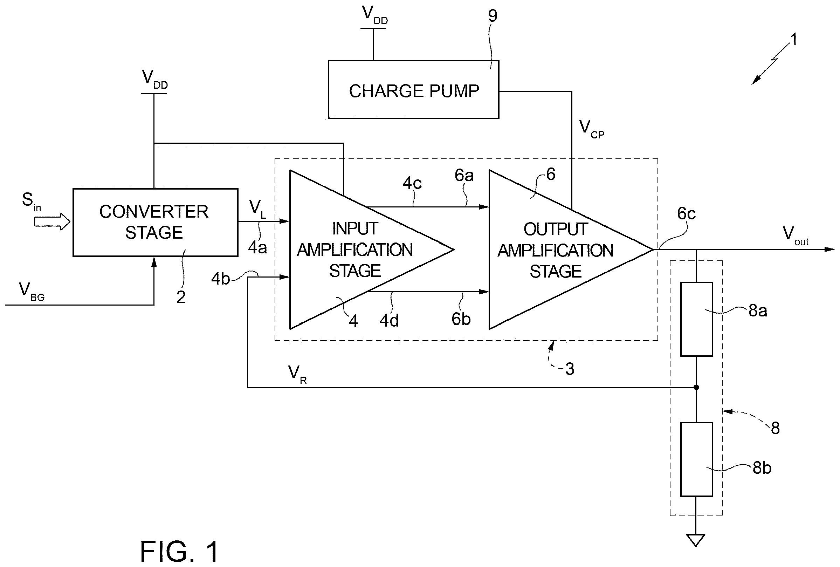

Figure 1 shows a general block diagram of a digital-to-analog converter device, designated as a whole by 1, of a known type, which may be used, for example, for generation of the biasing voltages required in a nonvolatile memory of the flash type.

The digital-to-analog converter 1 comprises an input conversion stage 2, in particular of the R2R type (i.e., with resistive ladder), designed to receive over an input bus, for example from a control device of the nonvolatile-memory device (here not illustrated), a digital signal $S_{in}$ indicative of the biasing voltage that is to be generated, and also, for example from a band-gap generator, a reference voltage $V_{BG}$. The input conversion stage 2 is further designed to generate an analog input voltage $V_L$, as a function of the digital signal $S_{in}$ and of the reference voltage $V_{BG}$.

The digital-to-analog converter 1 further comprises an amplifier circuit 3, which includes:

an input amplification stage 4, which comprises an operational-amplifier stage, in particular a fully differential transconductance amplifier (OTA - Operational Transconductance Amplifier), having a first input 4a, which receives the input voltage $V_L$, a second input 4b, which is designed to receive a feedback voltage $V_R$ for implementing a voltage control loop, and a first differential output 4c and a second differential output 4d;

an output amplification stage 6, which has a first input 6a and a second input 6b connected to the first and second differential outputs 4c, 4d of the input amplification stage 4, and an output 6c, which defines the output of the amplifier circuit 3 and supplies an output voltage $V_{out}$, amplified by a desired amplification factor with respect to the input voltage $V_L$; for example, the total gain of the amplification chain formed by the input amplification stage 4 and by the output amplification stage 6 may be equal to 20; and

a divider stage 8, which is connected to the output 6c of the output amplification stage 6 and is designed to supply the feedback voltage $V_R$, as a division of the output voltage $V_{out}$, in order to implement feedback control of the value of the same output voltage $V_{out}$; in the example illustrated, the divider stage 8 is of the resistive type and thus comprises a first resistor 8a and a second resistor 8b, which are connected in series between the output 6c and a ground-reference terminal and define a feedback node, present on which is the feedback voltage $V_R$ (it is, however, clear that the divider stage 8 could be of the capacitive type, in any case guaranteeing a reduced absorption of electrical current).

A charge pump 9 further generates a boosted voltage $V_{CP}$ of a suitable value, for example 11 V, starting from a logic supply voltage $V_{DD}$, for supply of the output amplification stage 6.

On account of the high inefficiency of the charge pump 9, the static consumption of the amplifier circuit 3, and in particular of the output amplification stage 6, is required to be particularly low, for any operating condition. In fact, the aforesaid static consumption is amplified, in use, by the inefficiency factor of the charge pump 9 (which may, for example, be equal to 20).

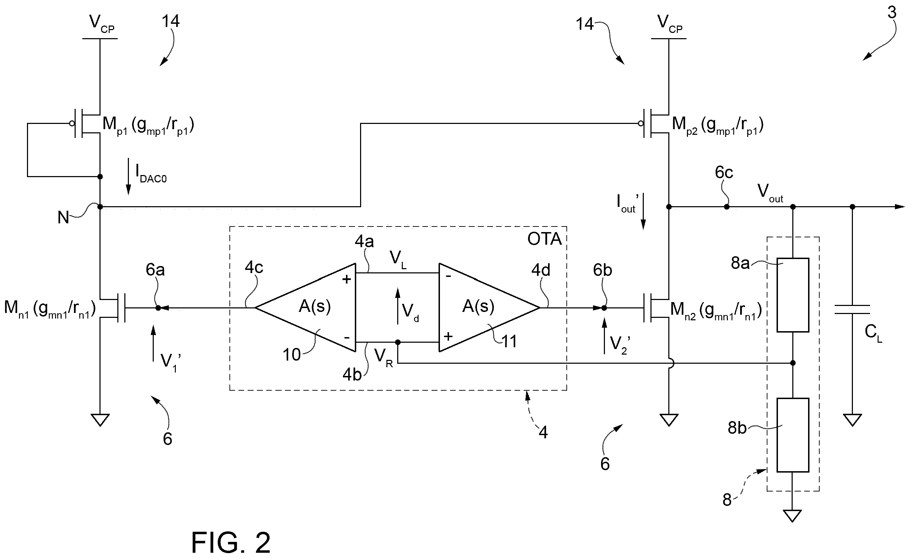

As illustrated in greater detail in Figure 2 (where a load capacitor $C_L$ connected to the output 6c of the amplifier circuit 3 is further illustrated), the input amplification stage 4 comprises a first operational amplifier 10 and a second operational amplifier 11, of the OTA type, which have their differential inputs in common (in other words, connected in parallel at input) and operate in phase opposition. In particular, the non-inverting input of the first operational amplifier 10 is connected to the inverting input of the second operational amplifier 11 and receives the input voltage $V_L$, whereas the inverting input of the first operational amplifier 10 is connected to the non-inverting input of the second operational amplifier 11 and receives the feedback voltage $V_R$. Designated by

$V_d$ in Figure 2 is the differential voltage between the inputs of the operational amplifiers 10, 11.

The output amplification stage 6 comprises: a first NMOS output transistor $M_{n1}$, having its gate terminal connected to the output 4c of the first operational amplifier 10 and on which a first differential voltage $V_1$ is present, a first conduction terminal connected to an internal node N, and a second conduction terminal connected to ground; and a second NMOS output transistor $M_{n2}$, which has corresponding characteristics (in terms of the resistance $r_n$ and transconductance $g_{mn}$ parameters) to those of the first NMOS output transistor $M_{n1}$, and has its gate terminal connected to the output 4d of the second operational amplifier 11 and on which a second differential voltage $V_2$ is present, a first conduction terminal connected to the output 6c, and a second conduction terminal connected to ground.

The output amplification stage 6 further comprises a current mirror 14, formed by: a first diode-connected PMOS mirror transistor $M_{p1}$, which has its gate terminal connected to the internal node N, a first conduction terminal that receives, in this example, the boosted voltage $V_{CP}$ from the charge pump 9, and a second conduction terminal connected to the gate terminal; and a second PMOS mirror transistor $M_{p2}$, having its gate terminal connected to the internal node N, a first conduction terminal that receives, in the example, the boosted voltage $V_{CP}$ from the charge pump 9, and a second conduction terminal connected to the output 6c. The first and second PMOS mirror transistors $M_{p1}$, $M_{p2}$ also have corresponding characteristics (in terms of the resistance $r_p$ and transconductance $g_{mp}$ parameters).

The amplifier circuit 3 implements a voltage control loop, where the value of the output voltage $V_{out}$ is determined by the value of the input voltage $V_L$, being substantially equal to $\beta \cdot V_L$ (where $\beta$ is the gain of the amplification chain and also corresponds to the inverse of the division factor implemented by the divider stage 8).

The above control loop envisages that an increase of the input voltage $V_L$ will cause an increase of the differential voltage $V_1$ and a corresponding decrease of the differential voltage $V_2$. Consequently, the output voltage $V_{out}$ increases, and the feedback voltage $V_R$ increases accordingly until it substantially reaches the value of the input voltage $V_L$, bringing the circuit back into the condition of equilibrium.

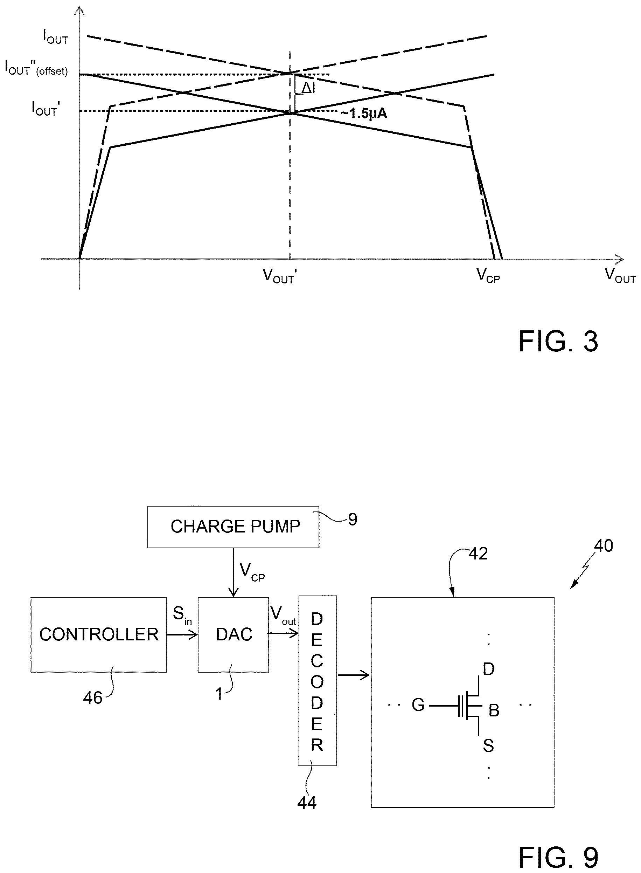

The operating point (or equilibrium point) of the output amplification stage 6 is determined by the crossing point of the output characteristics of the NMOS transistor $M_{n2}$ and PMOS transistor $M_{p2}$, as illustrated by the solid-line curves in Figure 3. In particular, corresponding to this operating point is a desired value $V_{out}'$ of the output voltage $V_{out}$, a given value of output current $I_{out}'$ (which determines the static consumption of the amplifier circuit 3), in the example 1.5 μA, and values $V_1'$ and $V_2'$ for the differential voltages $V_1$ and $V_2$.

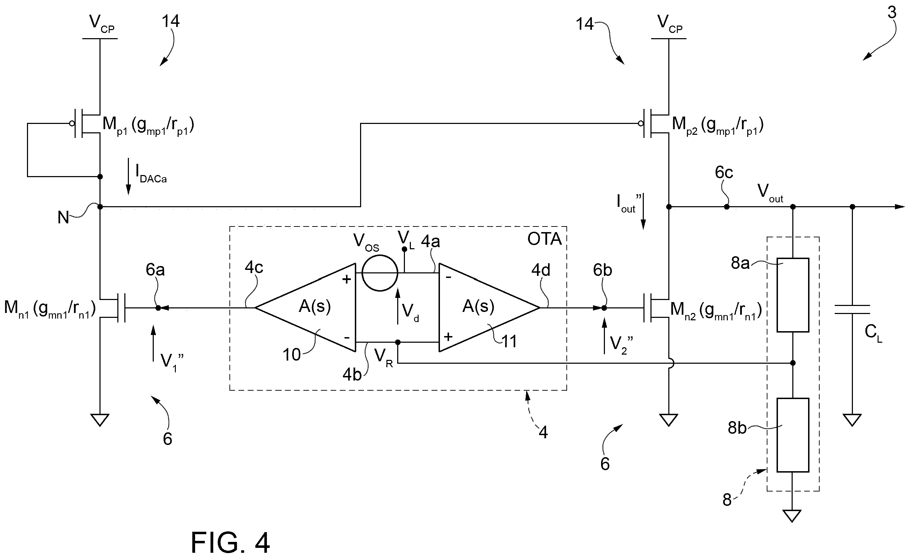

The present Applicant has realized that the presence of mismatches in the amplifier circuit 3, in particular in the characteristics of the NMOS transistors $M_{n1}$, $M_{n2}$, of the PMOS transistors $M_{p1}$, $M_{p2}$, and of the operational amplifiers 10 and 11, may cause an unbalancing of the differential inputs 4a, 4b of the input amplification stage 4. This unbalancing is represented schematically as an offset, designated by $V_{os}$ in Figure 4, assumed as being concentrated in a voltage generator at the input of the operational amplifiers 10, 11 (by way of example, the offset $V_{os}$ is represented on the non-inverting input of the first operational amplifier 10, with positive pole on the same non-inverting input of the operational amplifier 10 and negative pole on the differential input 4a).

The aforesaid offset $V_{os}$ causes a different operating point of the output amplification stage 6, as shown in Figure 3 with a dashed line (with reference to a possible example), highlighted in which is the new value of output current $I_{out}''$ at the same output voltage $V_{out}$, which differs by a current deviation $\Delta I$ from the desired operating point $I_{out}'$, and to which different values $V_1''$ and $V_2''$, for the differential voltages $V_1$ and $V_2$, correspond.

The operating point consequently comes to rest on different output characteristics, with a static operation point, which involves a possible increase in the consumption of static current.

The current deviation $\Delta I$ has particularly negative effects in the case where the amplifier circuit 3 is used in the digital-to-analog converter 1 (as illustrated in Figure 1), supplied by the charge pump 9. In fact, considering an inefficiency factor $\eta$ for the charge pump 9, the consumption of current by the electrical supply of the digital-to-analog converter device 1 has a total increase equal to $\eta \cdot \Delta I$.

US 6 433 521 B1 discloses a regulator comprising a voltage-regulated terminal, a first operational amplifier and a non-inverting input terminal thereof coupled to a reference voltage. An inverting input terminal of a second operational amplifier is coupled to the reference voltage. A control gate of a first transistor is coupled to an output terminal of the first operational amplifier. A source of the first transistor is coupled to an inverting input terminal of the first operational amplifier to form a feedback network and to provide a stable circuit of sourcing current. A control gate of a second transistor is coupled to an output terminal of the second operational amplifier and a drain of the second transistor to a non-inverting input terminal of the second operational amplifier to form the feedback network and to provide a stable circuit of sinking current.

US 2006/197513 A1 discloses a LDO voltage regulator circuit with common-mode feedback. The LDO voltage regulator includes an error amplifier with a common-mode feedback unit, a pass device and a compensation circuit. A signal from the pass device acts as an input signal to the error amplifier and is compared with another input signal, producing a differential signal. The differential signal is amplified and then provided to the pass device. A capacitor in the compensation unit provides frequency compensation to the LDO voltage regulator. The common-mode feedback unit incorporated into the error amplifier improves a slew rate of a gate voltage of the pass device.

The need is thus certainly felt to provide an improved solution for the amplifier circuit, which will enable the problems highlighted previously to be solved, or at least attenuated.

The aim of the present invention is to meet the above need.

Consequently, according to the present invention an amplifier circuit, for example for a digital-to-analog converter device used in a nonvolatile-memory device of the flash type, and a corresponding control method are provided, as defined in the annexed claims.

For a better understanding of the present invention, preferred embodiments thereof are now described, purely by way of non-limiting example and with reference to the attached drawings, wherein:

- Figure 1 shows a general layout of a digital-to-analog converter device, of a known type, including an amplifier circuit;
- Figure 2 shows in greater detail an implementation of the amplifier circuit of Figure 1;
- Figure 3 shows plots of electrical quantities in the amplifier circuit;
- Figure 4 shows the amplifier circuit in the presence of offset due to a mismatch in the circuit components;
- Figure 5 shows a diagram of an amplifier circuit, according to one aspect of the present solution;
- Figure 6 shows in greater detail an embodiment of the amplifier circuit of Figure 5;
- Figure 7 shows in greater detail a circuit implementation of a control stage in the amplifier circuit of Figure 5;
- Figures 8a and 8b show plots regarding the static consumption performance of the amplifier circuit according to the known art and according to the present solution, respectively; and
- Figure 9 is a block diagram of a memory device including the digital-to-analog converter device and the corresponding amplifier circuit, according to one aspect of the present solution.

With reference once again to Figures 2 and 4, the present Applicant has realized that, in the absence of offset, the biasing point of the circuit $V_L = V_{L0}$ is such that

$$V_1 = V_1' = V_2 = V_2' = V_0$$

In the presence of the discussed offset $V_{OS}$, the value of the input voltage $V_L$ may no longer be equal to $V_{L0}$. In fact, in this case we would have $V_1 >> (V_2 = V_0)$, and the system would not be in a condition of equilibrium.

To return to a condition of equilibrium, the input voltage $V_L$ has to increase with respect to the situation without offset, forcing, on the one hand, the operational amplifier 11 to supply a value of $V_2 = V_2'' > V_0$ and, on the other, the operational amplifier 10 to supply a value of $V_1 = V_1'' > V_0$.

Both transistors $M_{n1}$ and $M_{n2}$ thus work with higher currents with respect to what is desirable in the circuit without offset, albeit enabling the system to reach a situation of equilibrium.

The present Applicant has thus realized that a level of current (and thus of consumption) higher than what desirable in the design stage is coupled to a value of the differential voltages $V_1$ and $V_2$ greater than $V_0$.

In other words, the common-mode value of the differential voltages $V_1$ and $V_2$ with respect to a reference value $V_0$ is indicative of the current consumption. A high consumption is equivalent to a high value of $V_1$ and $V_2$ with respect to the reference value $V_0$; a low consumption is equivalent to a low value of $V_1$ and $V_2$ with respect to the reference value $V_0$.

As will be described in detail hereinafter, one aspect of the present solution envisages implementation, in an amplifier circuit, which comprises an input stage with a pair of operational amplifiers operating in phase opposition on the same differential inputs, for example for use in a digital-to-analog converter device, of a common-mode control stage, coupled to the differential outputs of the operational amplifiers in order to eliminate, or at least reduce, the undesirable effects of consumption associated to mismatches in the circuit components that may be present in the amplifier circuit.

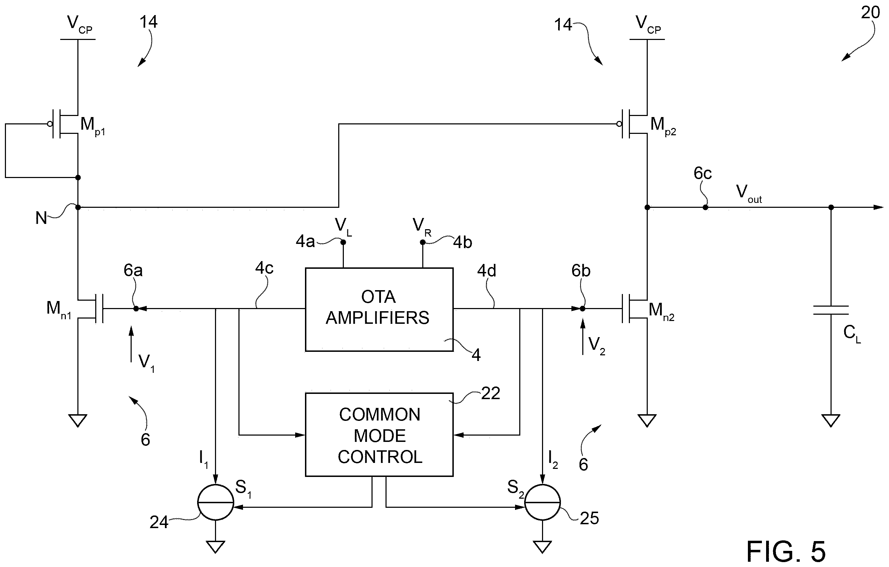

As illustrated in Figure 5 (where elements that are similar to others already described previously are designated by the same reference numbers and are not described any further), the amplifier circuit, here designated by 20, has a configuration substantially similar to what has been discussed previously with reference to Figure 2, and in particular includes an input amplification stage 4 (here illustrated schematically) having a differential configuration with two operational amplifiers with inputs in parallel and phase opposition, and an output amplification stage 6. For reasons of simplicity of illustration, the divider stage 8, which is in any case present and supplies the feedback voltage $V_R$ to the input 4b of the input amplification stage 4, is not illustrated in Figure 5.

According to one aspect of the present solution, the amplifier circuit 20 further comprises a common-mode control stage 22, coupled to the differential outputs 4c, 4d of the input amplification stage 4.

The common-mode control stage 22 is configured to react to a common-mode variation of the differential voltages $V_1$ and $V_2$, imposing a current of appropriate value on the gate terminals of the NMOS output transistors $M_{n1}$, $M_{n2}$ in order to eliminate, or at least reduce, the common-mode variation and regulate the value of the differential voltages $V_1$ and $V_2$ around the desired working point (to reduce accordingly the current deviation ΔI and the static consumption associated thereto).

In particular, a respective current generator 24, 25 is in this case coupled to the gate terminal of the NMOS output transistors $M_{n1}$, $M_{n2}$ in order to force a respective regulation current $I_1$, $I_2$. Current generators 24, 25 are controlled, with a respective control signal $S_1$, $S_2$ by the common-mode control stage 22, which, in a possible embodiment, is configured to compare the value of the differential voltages $V_1$ and $V_2$ with a target value generated internally and generate the control signals $S_1$, $S_2$ as a function of the comparison result to control the value of the regulation currents $I_1$, $I_2$.

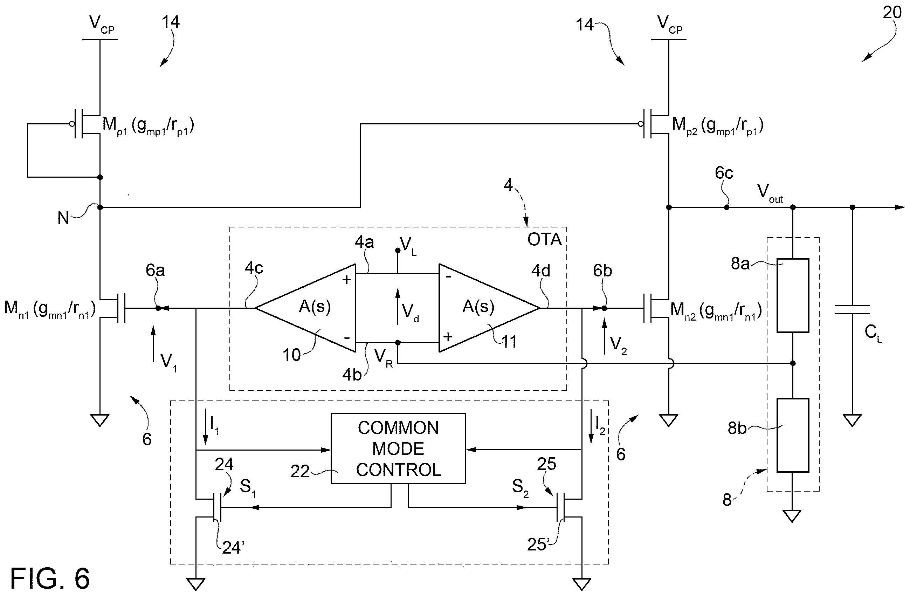

As illustrated in greater detail in Figure 6 (where operational amplifiers 10, 11 of the input amplification stage 4 are illustrated), in a possible embodiment the current generators 24, 25 are implemented by a respective NMOS generator transistor 24', 25', each of which has its gate terminal that is connected to a respective output of the common-mode control stage 22 and receives the respective control signal $S_1$, $S_2$, a first conduction terminal connected to the gate terminal of the respective NMOS output transistor $M_{n1}$, $M_{n2}$, and a second conduction terminal connected to ground.

Operation of the common-mode control stage 22 envisages in general reaction to a common-mode variation of the differential voltages $V_1$ and $V_2$ (due in particular to an offset $V_{os}$ - here not represented - associated to mismatches in the characteristics of the circuit components) by forcing a corresponding current $I_1$, $I_2$ on the gate terminals of the NMOS output transistors $M_{n1}$, $M_{n2}$ in such a way as to cause a consequent variation of the aforesaid differential voltages $V_1$ and $V_2$, bringing the amplifier circuit 20 back to the desired working point (thus compensating the presence of the aforesaid offset $V_{os}$).

This common-mode-control mechanism adds to the feedback control loop for control of the output voltage $V_{out}$ as a function of the input voltage $V_L$, given that, advantageously, it is much faster than the same feedback control loop.

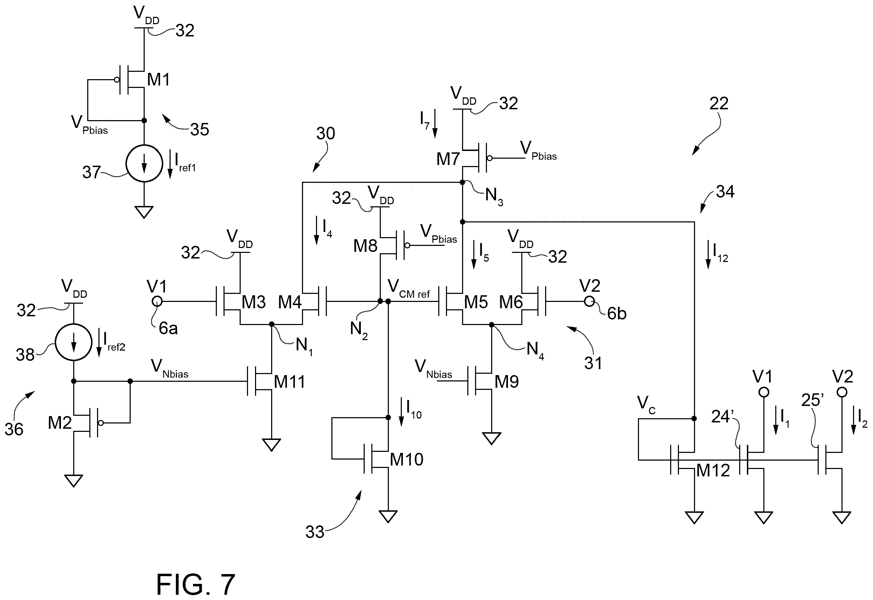

With reference to Figure 7, a possible circuit implementation of the common-mode control stage 22 is now discussed, which implements the control mechanism described previously and comprises: a first differential branch 30 and a second differential branch 31, which are coupled, respectively, to the first and second inputs 6a, 6b of the output amplification stage 6.

In detail, the first differential branch 30 includes: a first NMOS transistor M3, having its gate terminal that is connected to the first input 6a and receives the differential voltage $V_1$, a first conduction terminal that is connected to a supply terminal 32 (and receives the supply voltage $V_{DD}$), and a second conduction terminal connected to a first internal node N1; a second NMOS transistor M4, having its gate terminal connected to a second internal node N2, a first conduction terminal connected to a third internal node N3, and a second conduction terminal which is also connected to the first internal node N1; and a third NMOS transistor M11 having its gate terminal that receives a first biasing voltage $V_{Nbias}$, a first conduction terminal connected to the first internal node N1, and a second conduction terminal connected to ground.

Analogously, the second differential branch 31 includes a respective first NMOS transistor M6, having its gate terminal that is connected to the second input 6b and receives the differential voltage $V_2$, a first conduction terminal connected to the supply terminal 32, and a second conduction terminal connected to a fourth internal node N4; a respective second NMOS transistor M5, having its gate terminal connected to the second internal node N2, a first conduction terminal connected to the third internal node N3, and a second conduction terminal, which is also connected to the fourth internal node N4; and a respective third NMOS transistor M9 having its gate terminal that receives the first biasing voltage $V_{Nbias}$, a first conduction terminal connected to the fourth internal node N4, and a second conduction terminal connected to ground.

The common-mode control stage 22 further comprises a reference-generator branch 33 including: a PMOS reference transistor M8, having its gate terminal that receives a second biasing voltage $V_{Pbias}$, a first conduction terminal connected to the supply terminal 32, and a second conduction terminal connected to the second internal node N2; and a diode-connected NMOS reference transistor M10, having a first conduction terminal connected to the second internal node N2, its gate terminal connected to the first conduction terminal, and a second conduction terminal connected to ground.

The common-mode control stage 22 further comprises a control branch 34, including: an NMOS control transistor M12, and a PMOS current-supply transistor M7.

The NMOS control transistor M12, which is diode-connected, has a first conduction terminal connected to the third internal node N3, its gate terminal, which is connected to the first conduction terminal and on which a control voltage $V_c$ is present, and a second conduction terminal connected to ground. Furthermore, the gate terminal of the NMOS control transistor M12 is connected to the gate terminal of both NMOS generator transistors 24', 25', and the control voltage $V_c$ thus determines the value of the regulation currents $I_1$, $I_2$, thus in this case constituting the respective control signal $S_1$, $S_2$.

The PMOS current-supply transistor M7 has a first conduction terminal connected to the supply terminal 32, its gate terminal receiving the second biasing voltage $V_{Pbias}$, and a second conduction terminal connected to the third internal node N3.

The common-mode control stage 22 further comprises: a p-biasing generator 35 and a n-biasing generator 36.

The p-biasing generator 35 includes a diode-connected PMOS transistor M1, having a first conduction terminal that is connected to the supply terminal 32 (and receives the supply voltage $V_{DD}$), a second conduction terminal, which is connected to a first reference-current generator 37 (in turn connected to ground) and generates a first reference current $I_{ref1}$, and its gate terminal, which is connected to the second conduction terminal and on which the second biasing voltage $V_{Pbias}$ is present.

The n-biasing generator 36 includes: a diode-connected PMOS transistor M2, having a first conduction terminal, which is connected to a second reference-current generator 38 (in turn connected to the supply terminal 32) and generates a second reference current $I_{ref2}$, a second conduction terminal connected to ground, and its gate terminal, which is connected to the first conduction terminal and on which the first biasing voltage $V_{Nbias}$ is present.

During operation of the common-mode control stage 22, the PMOS reference transistor M8 and NMOS reference transistor M10 determine on the second internal node N2 generation of a common-mode reference voltage $V_{CMref}$, the value of which is indicative of the working point (and of the associated consumption of static current) desired for the amplifier circuit 3 (which varies as a function of the working conditions of the same amplifier circuit 3).

The first and second differential branches implement the comparison between the first differential voltage $V_1$ and the second differential voltage $V_2$, respectively, and the common-mode reference voltage $V_{CMref}$, and generate an unbalancing current 14 and 15, respectively, as a function of the comparison.

The control current 112 that circulates in the NMOS control transistor M12 is a function of the current 17 generated by the PMOS current-supply transistor M7 and of the value of the unbalancing currents 14 and 15 and in turn determines the value of the regulation currents $I_1$, $I_2$ and thus of the differential voltages $V_1$ and $V_2$, according to the action of control exerted by the common-mode control stage 22.

Basically, the NMOS control transistor M12 forms a current mirror with the NMOS generator transistors 24', 25', and the regulation currents $I_1$, $I_2$ are determined by the value of the control current 112 and by a respective mirroring factor.

In particular, for high values of both differential voltages $V_1$ and $V_2$ (on account of the presence of the offset $V_{os}$ at the inputs of the input amplifier stage 4), the unbalancing currents 14 and 15 have a low value, and substantially all the current 17 generated by the PMOS current-supply transistor M7 circulates in the NMOS control transistor M12, causing an increase of the control current 112. Consequently, the control voltage $V_c$ rises, and the regulation currents $I_1$, $I_2$ also rise, causing a corresponding decrease of differential voltages $V_1$ and $V_2$.

The common-mode control stage 22 thus reacts to the presence of a simultaneous increase of the differential voltages $V_1$ and $V_2$ by causing rapid decrease thereof and return to a desired working point of the amplification circuit 3.

If the differential voltages $V_1$ and $V_2$ both have, instead, a low value, the current 17 generated by the PMOS current-supply transistor M7 circulates substantially entirely through NMOS transistors M4 and M5 of the two differential branches so that the control current 112 in the NMOS control transistor M12 has a low value, thus determining a corresponding low value of the regulation currents $I_1$, $I_2$ (in this case, the control action is substantially negligible).

During the transients (dynamic working condition), when the differential voltages $V_1$ and $V_2$ have values very different from one another and in phase opposition, the unbalancing currents 14 and 15 have substantially opposite variations, thus determining a substantially negligible resulting variation of the control current 112 and a corresponding negligible control action by the control voltage $V_c$.

In other words, the control action exerted by the common-mode control stage 22 does not affect the dynamic operation of the amplifier circuit 3. Furthermore, the same common-mode control action is, thanks to the circuit configuration described, very fast as compared to the differential control loop implemented by the amplifier circuit 3.

The advantages of the solution proposed are clear from the foregoing description.

In particular, the amplifier circuit 20 enables elimination, or in any case reduction, of the effects of possible mismatches between the components, which could cause lack of symmetry in the inputs of the operational amplifiers and a consequent offset $V_{os}$. In this way, the static consumption of the amplifier circuit 20 does not undergo undesirable increases.

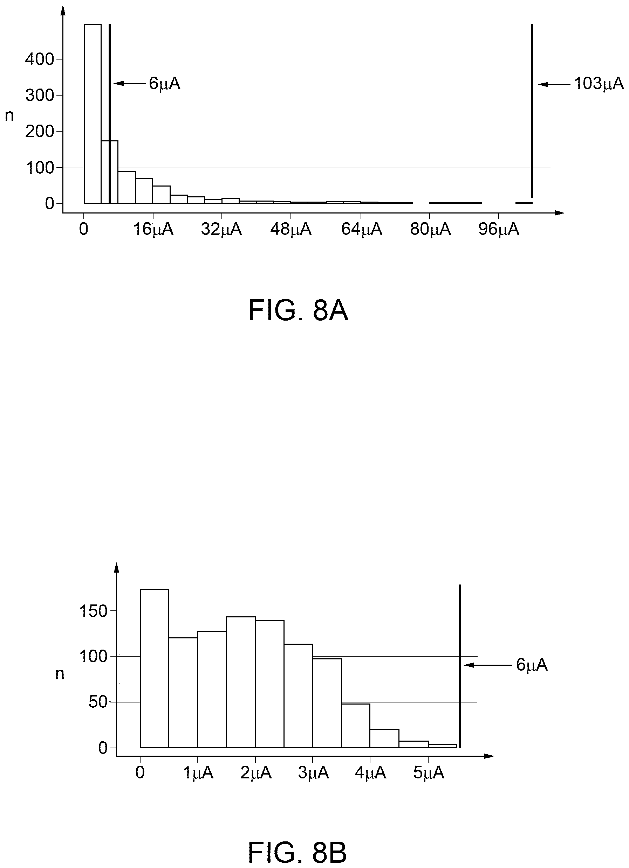

In this regard, Figures 8a and 8b compare the static current consumption of an amplifier circuit according to the known art (i.e., without a compensation stage, for example as described in Figure 2) and of the amplifier circuit 20 according to the present solution, provided with the common-mode control stage 22.

As highlighted by the statistical distribution illustrated in Figure 8a, the static current consumption of the circuit according to the prior art has a maximum value of approximately 103 $\mu$A, and a mean value of approximately 9 $\mu$A. The amplifier circuit 20 according to the present solution, as illustrated in Figure 8b, has, instead, a maximum static current consumption of approximately 6 $\mu$A, with a mean value of just 1.8 $\mu$A.

Advantageously, the reduction in the static current consumption is obtained without altering the dynamic characteristics of gain and phase of the amplification stage and the characteristics of the external differential-voltage control loop.

In particular, the solution described does not introduce any resistive and/or capacitive loads in the control loop and does not alter the stability characteristics thereof.

Furthermore, the circuit configuration of the common-mode control stage 22 envisages the use of solely low-voltage transistors, with a consequent low total occupation of area.

The characteristics highlighted are particularly advantageous in the case where the amplifier circuit 20 is used in combination with a charge pump (as in the digital-to-analog converter 1), a case where the poor efficiency of the same charge pump would amplify in fact possible current deviations ΔI and consequently the associated static consumption levels.

In this regard, Figure 9 is a schematic representation of a nonvolatile memory device 40, in particular of the flash type (only the parts relevant for the present discussion are illustrated in Figure 9).

The nonvolatile memory device 40 comprises: an array of memory cells 42 (only one of which is illustrated by way of example); a decoder 44, designed to address the memory cells 42 for reading and programming operations; the digital-to-analog converter device, designated once again by 1, which is connected to the decoder 44 and includes the amplifier circuit 20; the charge pump 9, which supplies the boosted voltage $V_{CP}$ to the amplifier circuit 20; and a controller 46, for example including a microprocessor or a microcontroller (or similar processing element), connected to the digital-to-analog converter device 1.

The controller 46 supplies the digital input signals $S_{in}$, indicating the biasing voltage that is to be generated, to the digital-to-analog converter device 1, according to the read or program (or verify) operations that are to be carried out.

The digital-to-analog converter 1 consequently generates the output voltages $V_{out}$, which subsequently reach the memory cells 42 via the decoder 44.

Finally, it is clear that modifications and variations may be made to what has been described and illustrated herein, without thereby departing from the scope of the present invention, as defined in the annexed claims.

In particular, it is once again emphasized that the solution described may find advantageous application in all devices that envisage use of an amplifier circuit with a differential input stage including a pair of operational amplifiers with inputs in common and in phase opposition, in order to reduce the static current consumption due to offsets present on the same inputs.

**Claims**

1. An amplifier circuit (20), comprising:

   an input amplification stage (4) including a first operational amplifier (10) with a first differential input and a first output (4c); and further including a second operational amplifier (11) with a second differential input and a second output (4d), wherein a non-inverting input (4a) of the first differential input of the first operational amplifier is connected to an inverting input of the second differential input of the second operational amplifier and is designed to receive an input voltage ($V_L$), and an inverting input (4b) of the first differential input of the first operational amplifier is connected to a non-inverting input of the second differential input of the second operational amplifier and is designed to receive a feedback voltage ($V_R$);

   an output amplification stage (6), which has a first input (6a) and a second input (6b) that are connected to a respective output of the first and second outputs (4c, 4d) of the first and second operational amplifiers (10, 11) of the input amplification stage (4), and is designed to supply at an output (6c) an output voltage ($V_{out}$) linked to the input voltage ($V_L$) by an amplification factor ($\beta$); and

   a feedback stage (8), which is connected to the output (6c) of the output amplification stage (6) and is designed to generate the feedback voltage ($V_R$) as a function of the output voltage ($V_{out}$),

   **characterized by** comprising a common-mode control stage (22), which is connected to the first and second outputs (4c, 4d) of the first and second operational amplifiers (10, 11) of the input amplification stage (4) for receiving a first differential voltage ($V_1$) and a second differential voltage ($V_2$), respectively, and is configured to implement a comparison of the first differential voltage ($V_1$) and, respectively, the second differential voltage ($V_2$), with a reference voltage ($V_{CMref}$), and to force a respective regulation current ($I_1$, $I_2$) of first and second current generators (24, 25) connected to a respective input of the first and second inputs (6a, 6b) of the output amplification stage (6), with a regulation current value which is a function of an outcome of the respective comparison, in order to compensate a simultaneous increase of said first differential voltage ($V_1$) and said second differential voltage ($V_2$).

2. The circuit according to claim 1, wherein said common-mode control stage (22) being configured to generate, as a function of said comparison, a first control signal ($S_1$) and a second control signal ($S_2$) for controlling said first current generator (24) and said second current generator (25) for generation of said regulation currents ($I_1$, $I_2$).

3. The circuit according to claim 2, wherein said first current generator (24) and said second current generator (25) comprise a respective generator transistor (24', 25'), which has a control terminal connected to said common-mode control stage (22) for receiving said first control signal ($S_1$) and said second control signal ($S_2$), respectively, a first conduction terminal connected to a respective input (6a, 6b) of said output amplification stage (6), and a second conduction terminal connected to a reference-potential terminal.

4. The circuit according to any one of the preceding claims, wherein said common-mode control stage (22) comprises:

a reference-generator branch (33), configured to generate said reference voltage ($V_{CMref}$);
a first differential branch (30) and a second differential branch (31), which are configured to compare said first differential voltage ($V_1$) and said second differential voltage ($V_2$), respectively, with said reference voltage ($V_{CMref}$) and generate a first unbalancing current (14) and a second unbalancing current (I5), respectively; and
a control branch (34), configured to cause generation of the regulation currents ($I_1$, $I_2$) as a function of the value of the first unbalancing current (14) and the second unbalancing current (15).

5. The circuit according to claim 4, wherein said control branch (34) comprises: a current-supply transistor (M7), configured to generate a supply current (17) on an internal node (N3), further connected to which are said first differential branch (30) and said second differential branch (31), and a diode-connected control transistor (M12), connected to the internal node (N3); wherein a control current (112), traversing the control transistor (M12), is a function of the supply current (17) and of the first unbalancing current (14) and second unbalancing current (15).

6. The circuit according to claim 5, further comprising a first generator transistor (24') and a second generator transistor (25'), which are coupled in current-mirror configuration to the control transistor (M12) and are designed to generate said regulation currents ($I_1$, $I_2$) as a function of said control current (112) and of a respective mirroring factor.

7. The circuit according to any one of the preceding claims, wherein said feedback stage (8) comprises a divider, designed to generate said feedback voltage ($V_R$) as division of said output voltage ($V_{out}$).

8. The circuit according to any one of the preceding claims, wherein said output amplification stage (8) comprises: a first output transistor ($M_{n1}$), which is connected between an internal node (N) and a reference-potential terminal and has its control terminal connected to said first input (6a); a second output transistor ($M_{n1}$), which is connected between said output (6c) and said reference-potential terminal and has its control terminal connected to said second input (6b); and a current mirror (14), which is supplied by a supply voltage ($V_{CP}$) and has a first mirroring branch and a second mirroring branch, which are connected to said internal node (N) and to said output (6c), respectively.

9. The circuit according to any one of the preceding claims, wherein said first operational amplifier (10) and said second operational amplifier (11) are transconductance amplifiers of the fully differential type.

10. A digital-to-analog converter device (1), comprising:

the amplifier circuit (20) according to any one of the preceding claims;
an input conversion stage (2) designed to receive a digital signal ($S_{in}$) and to generate said input voltage ($V_L$) for said amplifier circuit (20); and
a charge-pump stage (9), designed to generate a supply voltage ($V_{CP}$), having a boosted value with respect to an input voltage ($V_{DD}$), for the output amplification stage (6) of said amplifier circuit (20).

11. A nonvolatile memory (40), comprising an array of memory cells (42) and the digital-to-analog converter device (1) according to claim 10, which is designed to generate biasing voltages for said memory cells (42).

12. A method for controlling an amplifier circuit (20), comprising:

an input amplification stage (4) including a first operational amplifier (10) with a first differential input and a first output (4c); and further including a second operational amplifier (11) with a second differential input and a second output, wherein a non-inverting input (4a) of the first differential input of the first operational amplifier is connected to an inverting input of the second differential input of the second operational amplifier and is designed to receive an input voltage ($V_L$), and an inverting input (4b) of the first differential input of the first operational amplifier is connected to a non-inverting input of the second differential input of the second operational amplifier and is designed to receive a feedback voltage ($V_R$);
an output amplification stage (6), which has a first input (6a) and a second input (6b) that are connected to a respective output of the first and second outputs (4c, 4d) of the first and second operational amplifiers (10, 11) of the input amplification stage (4) and is designed to supply at an output (6c) an output voltage ($V_{out}$) linked to the input voltage ($V_L$) by an amplification factor (β); and

a feedback stage (8), which is connected to the output (6c) of the output amplification stage (6) and is designed to generate the feedback voltage ($V_R$) as a function of the output voltage ($V_{out}$),

**characterized by** comprising: implementing with a common-mode control stage (22), which is connected to the first and second outputs (4c, 4d) of the first and second operational amplifiers (10, 11) of the input amplification stage (4), a comparison of a first differential voltage ($V_1$) and, respectively, a second differential voltage ($V_2$), which are present on the first and second outputs (4c, 4d) of the first and second operational amplifiers (10, 11) of the input amplification stage (4), with a reference voltage ($V_{CMref}$); and forcing a respective regulation current ($I_1$, $I_2$) of first and second current generators (24, 25), which are connected to a respective input of the first and second inputs (6a, 6b) of the output amplification stage (6), with a regulation current value which is a function of an outcome of the respective comparison, for compensating a simultaneous increase of said first differential voltage ($V_1$) and said second differential voltage ($V_2$).

13. The method according to claim 12, wherein the step of forcing the regulation current comprises generating, as a function of said comparison, a first control signal ($S_1$) and a second control signal ($S_2$) for controlling the first current generator (24) and the second current generator (25), respectively, for generation of said regulation currents ($I_1$, $I_2$).

**Patentansprüche**

1. Verstärkerschaltung (20), umfassend:

eine Eingangsverstärkungsstufe (4), die einen ersten Operationsverstärker (10) mit einem ersten Differentialeingang und einem ersten Ausgang (4c) enthält; und ferner einen zweiten Operationsverstärker (11) mit einem zweiten Differentialeingang und einem zweiten Ausgang (4d) enthält, wobei ein nicht-invertierender Eingang (4a) des ersten Differentialeingangs des ersten Operationsverstärkers mit einem invertierenden Eingang des zweiten Differentialeingangs des zweiten Operationsverstärkers verbunden ist und zum Empfangen einer Eingangsspannung ($V_L$) ausgelegt ist, und ein invertierender Eingang (4b) des ersten Differentialeingangs des ersten Operationsverstärkers mit einem nicht-invertierenden Eingang des zweiten Differentialeingangs des zweiten Operationsverstärkers verbunden ist und zum Empfangen einer Rückkopplungsspannung ($V_R$) ausgelegt ist; eine Ausgangsverstärkungsstufe (6), die einen ersten Eingang (6a) und einen zweiten Eingang (6b) aufweist, die mit einem entsprechenden Ausgang des ersten und zweiten Ausgangs (4c, 4d) der ersten und zweiten Operationsverstärker (10, 11) der Eingangsverstärkungsstufe (4) verbunden sind, und die dazu ausgelegt ist, an einem Ausgang (6c) eine mit der Eingangsspannung ($V_L$) durch einen Verstärkungsfaktor (β) verbundene Ausgangsspannung ($V_{out}$) zu liefern; und

eine Rückkopplungsstufe (8), die mit dem Ausgang (6c) der Ausgangsverstärkungsstufe (6) verbunden ist und zum Erzeugen der Rückkopplungsspannung ($V_R$) als Funktion der Ausgangsspannung ($V_{out}$) ausgelegt ist,

**dadurch gekennzeichnet, dass** sie eine Gleichtaktsteuerstufe (22) umfasst, die mit dem ersten und zweiten Ausgang (4c, 4d) des ersten und zweiten Operationsverstärkers (10, 11) der Eingangsverstärkungsstufe (4) zum Empfangen einer ersten Differentialspannung ($V_1$) bzw. einer zweiten Differentialspannung ($V_2$) verbunden ist und dazu ausgebildet ist, einen Vergleich der ersten Differentialspannung ($V_1$) bzw. der zweiten Differentialspannung ($V_2$) mit einer Referenzspannung ($V_{CMref}$) zu implementieren, und zum Erzwingen eines jeweiligen Regelstroms ($I_1$, $I_2$) von ersten und zweiten Stromgeneratoren (24, 25), die mit einem entsprechenden Eingang der ersten und zweiten Eingänge (6a, 6b) der Ausgangsverstärkungsstufe (6) verbunden sind, mit einem regelmäßigen Stromwert, der eine Funktion eines Ergebnis des jeweiligen Vergleichs ist, um einen gleichzeitigen Anstieg der ersten Differentialspannung ($V_1$) und der zweiten Differentialspannung ($V_2$) zu kompensieren.

2. Schaltung nach Anspruch 1, wobei die Gleichtaktsteuerstufe (22) zum Erzeugen eines ersten Steuersignals ($S_1$) und eines zweiten Steuersignals ($S_2$) zum Steuern des ersten Stromgenerators (24) und des zweiten Stromgenerators (25) zum Erzeugen der Regelströme ($I_1$, $I_2$) als Funktion des Vergleichs ausgebildet ist.

3. Schaltung nach Anspruch 2, wobei der erste Stromgenerator (24) und der zweite Stromgenerator (25) einen entsprechenden Generatortransistor (24', 25') umfassen, der einen mit der Gleichtaktsteuerstufe (22) verbundenen Steueranschluss zum Empfangen des ersten Steuersignals ($S_1$) bzw. des zweiten Steuersignals ($S_2$), einen mit einem entsprechenden Eingang (6a, 6b) der Ausgangsverstärkungsstufe (6) verbundenen ersten Leitungsanschluss und einen mit einem Referenzpotentialanschluss verbundenen zweiten Leitungsanschluss aufweist.

4. Schaltung nach einem der vorhergehenden Ansprüche, wobei die Gleichtaktsteuerstufe (22) umfasst:

    einen Referenzgeneratorzweig (33), der zum Erzeugen der Referenzspannung ($V_{CMref}$) ausgebildet ist;
    einen ersten Differentialzweig (30) und einen zweiten Differentialzweig (31), die zum Vergleichen der ersten Differentialspannung ($V_1$) bzw. der zweiten Differentialspannung ($V_2$) mit der Referenzspannung ($V_{CMref}$) und zum Erzeugen eines ersten Unsymmetriestroms (I4) bzw. eines zweiten Unsymmetriestroms (I5) ausgebildet sind; und
    einen Steuerzweig (34), der zum Bewirken der Erzeugung der Regelströme ($I_1$, $I_2$) als Funktion des Wertes des ersten Unsymmetriestroms (I4) und des zweiten Unsymmetriestroms (I5) ausgebildet ist.

5. Schaltung nach Anspruch 4, wobei der Steuerzweig (34) umfasst: einen Stromversorgungs-Transistor (M7), der zum Erzeugen eines Versorgungsstroms (I7) auf einem internen Knoten (N3) ausgebildet ist, mit dem ferner der erste Differentialzweig (30) und der zweite Differentialzweig (31) verbunden sind, und einen diodenverbundenen Steuertransistor (M12), der mit dem internen Knoten (N3) verbunden ist; wobei ein Steuerstrom (I12), der den Steuertransistor (M12) durchläuft, eine Funktion des Versorgungsstroms (I7) und des ersten Ungleichstroms (I4) und zweiten Ungleichstroms (I5) ist.

6. Schaltung nach Anspruch 5, ferner umfassend einen ersten Generatortransistor (24') und einen zweiten Generatortransistor (25'), die in Strom-Spiegel-Konfiguration mit dem Steuertransistor (M12) gekoppelt sind und zum Erzeugen der Regelströme ($I_1$, $I_2$) als Funktion des Steuerstroms (I12) und einem jeweiligen Spiegelungsfaktor ausgelegt sind.

7. Schaltung nach einem der vorhergehenden Ansprüche, wobei die Rückkopplungsstufe (8) einen Teiler umfasst, der zum Erzeugen der Rückkopplungsspannung ($V_R$) als Teilung der Ausgangsspannung ($V_{out}$) ausgelegt ist.

8. Schaltung nach einem der vorhergehenden Ansprüche, wobei die Ausgangsverstärkungsstufe (8) umfasst: einen ersten Ausgangstransistor ($M_{n1}$), der zwischen einem internen Knoten (N) und einem Referenzpotentialanschluss verbunden ist und dessen Steueranschluss mit dem ersten Eingang (6a) verbunden ist; einen zweiten Ausgangstransistor ($M_{n1}$), der zwischen dem Ausgang (6c) und dem Referenzpotentialanschluss verbunden ist und dessen Steueranschluss mit dem zweiten Eingang (6b) verbunden ist; und einen Stromspiegel (14), der von einer Versorgungsspannung ($V_{CP}$) gespeist wird und einen ersten Spiegelungszweig und einen zweiten Spiegelungszweig aufweist, die mit dem internen Knoten (N) bzw. mit dem Ausgang (6c) verbunden sind.

9. Schaltung nach einem der vorhergehenden Ansprüche, wobei der erste Operationsverstärker (10) und der zweite Operationsverstärker (11) Transkonduktanzverstärker des Differentialtyps sind.

10. Digital-Analog-Wandler-Vorrichtung (1), umfassend:

    die Verstärkerschaltung (20) nach einem der vorhergehenden Ansprüche;
    eine Eingangswandlerstufe (2), die zum Empfangen eines digitalen Signals ($S_{in}$) und zum Erzeugen der Eingangsspannung ($V_L$) für die Verstärkerschaltung (20) ausgelegt ist; und
    eine Ladungspumpenstufe (9), die zum Erzeugen einer Versorgungsspannung ($V_{CP}$) mit einem erhöhten Wert in Bezug auf eine Eingangsspannung ($V_{DD}$) für die Ausgangsverstärkungsstufe (6) der Verstärkerschaltung (20) ausgelegt ist.

11. Nichtflüchtiger Speicher (40), umfassend ein Array von Speicherzellen (42) und die Digital-Analog-Wandler-Vorrichtung (1) nach Anspruch 10, die zum Erzeugen von Vorspannungen für die Speicherzellen (42) ausgelegt ist.

12. Verfahren zum Steuern einer Verstärkerschaltung (20), umfassend:

    eine Eingangsverstärkungsstufe (4), die einen ersten Operationsverstärker (10) mit einem Differentialeingang und einem ersten Ausgang (4c) enthält; und ferner einen zweiten Operationsverstärker (11) mit einem zweiten Differentialeingang und einem zweiten Ausgang enthält, wobei ein nicht-invertierender Eingang (4a) des ersten Differentialeingangs des ersten Operationsverstärkers mit einem invertierenden Eingang des zweiten Operationsverstärkers verbunden ist und zum Empfangen einer Eingangsspannung ($V_L$) ausgelegt ist, und ein invertierender Eingang (4b) des ersten Differentialeingangs des ersten Operationsverstärkers mit einem nicht-invertierenden Eingang des zweiten Differentialeingangs des zweiten Operationsverstärkers verbunden ist und zum Empfangen einer Gegenspannung ($V_R$) ausgelegt ist;

eine Ausgangsverstärkungsstufe (6), die einen ersten Eingang (6a) und einen zweiten Eingang (6b) aufweist, die mit einem entsprechenden Ausgang des ersten und zweiten Ausgangs (4c, 4d) der ersten und zweiten Operationsverstärker (10, 11) der Eingangsverstärkungsstufe (4) verbunden sind, und die dazu ausgelegt ist, an einem Ausgang (6c) eine mit der Eingangsspannung ($V_L$) durch einen Verstärkungsfaktor ($\beta$) verbundene Ausgangsspannung ($V_{out}$) zu liefern; und

eine Rückkopplungsstufe (8), die mit dem Ausgang (6c) der Ausgangsverstärkungsstufe (6) verbunden ist und zum Erzeugen der Rückkopplungsspannung ($V_R$) als Funktion der Ausgangsspannung ($V_{out}$) ausgelegt ist, **dadurch gekennzeichnet, dass** sie umfasst: Implementieren mit einer Gleichtaktsteuerstufe (22), die mit dem ersten und zweiten Ausgang (4c, 4d) des ersten und zweiten Operationsverstärkers (10, 11) der Eingangsverstärkungsstufe (4) verbunden ist, einen Vergleich einer ersten Differentialspannung ($V_1$) bzw. einer zweiten Differentialspannung ($V_2$), die am ersten und zweiten Ausgang (4c, 4d) des ersten und zweiten Operationsverstärkers (10, 11) der Eingangsverstärkungsstufe (4) vorhanden sind, mit einer Referenzspannung ($V_{CMref}$); und Erzwingen eines jeweiligen Regelstroms ($I_1$, $I_2$) von ersten und zweiten Stromgeneratoren (24, 25), die mit einem entsprechenden Eingang der ersten und zweiten Eingänge (6a, 6b) der Ausgangsverstärkungsstufe (6) mit einem Regelstromwert verbunden sind, der eine Funktion eines Ergebnisses des jeweiligen Vergleichs ist, zum Kompensieren einer gleichzeitigen Erhöhung der ersten Differentialspannung ($V_1$) und der zweiten Differentialspannung ($V_2$).

**13.** Verfahren nach Anspruch 12, wobei der Schritt des Zwingens des Regelstroms das Erzeugen eines ersten Steuersignals ($S_1$) und eines zweiten Steuersignals ($S_2$) zum Steuern des ersten Stromgenerators (24) bzw. des zweiten Stromgenerators (25) zum Erzeugen der Regelströme als Funktion des Vergleichs umfasst. ($I_1$, $I_2$).

**Revendications**

**1.** Circuit amplificateur (20) comprenant :

un étage d'amplification d'entrée (4) comprenant un premier amplificateur opérationnel (10) ayant une première entrée différentielle et une première sortie (4c) ; et comprenant en outre un deuxième amplificateur opérationnel (11) ayant une deuxième entrée différentielle et une deuxième sortie (4d), dans lequel une entrée non inverseuse (4a) de la première entrée différentielle du premier amplificateur opérationnel est connectée à une entrée inverseuse de la deuxième entrée différentielle du deuxième amplificateur opérationnel et est conçue pour recevoir une tension d'entrée ($V_L$), et une entrée inverseuse (4b) de la première entrée différentielle du premier amplificateur opérationnel est connectée à une entrée non inverseuse de la deuxième entrée différentielle du deuxième amplificateur opérationnel et est conçue pour recevoir une tension de rétroaction ($V_R$);

un étage d'amplification de sortie (6), qui a une première entrée (6a) et une deuxième entrée (6b) qui sont connectées à une sortie respective des première et deuxième sorties (4c, 4d) des premier et deuxième amplificateurs opérationnels (10, 11) de l'étage d'amplification d'entrée (4), et est conçu pour fournir sur une sortie (6c) une tension de sortie ($V_{out}$) liée à la tension d'entrée ($V_L$) par un facteur d'amplification ($\beta$) ; et

un étage de rétroaction (8), qui est relié à la sortie (6c) de l'étage d'amplification de sortie (6) et est conçu pour générer la tension de rétroaction ($V_R$) en fonction de la tension de sortie ($V_{out}$), **caractérisé en ce qu'**il comprend un étage de commande en mode commun (22), qui est connecté aux première et deuxième sorties (4c, 4d) des premier et deuxième amplificateurs opérationnels (10, 11) de l'étage d'amplification d'entrée (4) pour recevoir respectivement une première tension différentielle ($V_1$) et une deuxième tension différentielle ($V_2$), et qui est configuré pour mettre en œuvre une comparaison de la première tension différentielle ($V_1$) et respectivement de la deuxième tension différentielle ($V_2$) avec une tension de référence ($V_{CMref}$), et pour forcer un courant de régulation respectif ($I_1$, $I_2$) d'un premier et un deuxième générateur de courant (24, 25) connectés à une entrée respective des première et deuxième entrées (6a, 6b) de l'étage d'amplification de sortie (6), avec une valeur de courant de régulation qui est fonction d'un résultat de la comparaison respective, afin de compenser une augmentation simultanée de ladite première tension différentielle ($V_1$) et de ladite deuxième tension différentielle ($V_2$).

**2.** Circuit selon la revendication 1, dans lequel ledit étage de commande en mode commun (22) est configuré pour générer, en fonction de ladite comparaison, un premier signal de commande ($S_1$) et un deuxième signal de commande ($S_2$) pour commander ledit premier générateur de courant (24) et ledit deuxième générateur de courant (25) pour la génération desdits courants de régulation ($I_1$, $I_2$).

**3.** Circuit selon la revendication 2, dans lequel ledit premier générateur de courant (24) et ledit deuxième générateur de courant (25) comprennent un transistor générateur respectif (24', 25'), qui a une borne de commande connectée audit étage de commande en mode commun (22) pour recevoir respectivement ledit premier signal de commande ($S_1$) et ledit deuxième signal de commande ($S_2$), une première borne de conduction connectée à une entrée respective (6a, 6b) dudit étage d'amplification de sortie (6), et une deuxième borne de conduction connectée à une borne de potentiel de référence.

**4.** Circuit selon l'une quelconque des revendications précédentes, dans lequel ledit étage de commande en mode commun (22) comprend :

une branche de générateur de référence (33) configurée pour générer ladite tension de référence ($V_{CMref}$) ;
une première branche différentielle (30) et une deuxième branche différentielle (31), qui sont configurées pour comparer respectivement ladite première tension différentielle ($V_1$) et ladite deuxième tension différentielle ($V_2$) avec ladite tension de référence ($V_{CMref}$) et pour générer respectivement un premier courant de dissymétrie (I4) et un deuxième courant de dissymétrie (I5) ; et
une branche de commande (34) configurée pour provoquer la génération des courants de régulation ($I_1$, $I_2$) en fonction de la valeur du premier courant de dissymétrie (I4) et du deuxième courant de dissymétrie (I5).

**5.** Circuit selon la revendication 4, dans lequel ladite branche de commande (34) comprend : un transistor d'alimentation en courant (M7), configuré pour générer un courant d'alimentation (I7) sur un nœud interne (N3), et sur lequel sont connectés en outre ladite première branche différentielle (30) et ladite deuxième branche différentielle (31), et un transistor de commande monté en diode (M12) connecté au nœud interne (N3) ; dans lequel un courant de commande (I12) qui traverse le transistor de commande (M12), est fonction du courant d'alimentation (I7) et du premier courant de dissymétrie (I4) et du deuxième courant de dissymétrie (I5).

**6.** Circuit selon la revendication 5, comprenant en outre un premier transistor générateur (24') et un deuxième transistor générateur (25') qui sont couplés en configuration de miroir de courant par rapport au transistor de commande (M12) et qui sont conçus pour générer lesdits courants de régulation ($I_1$, $I_2$) en fonction dudit courant de commande (I12) et d'un facteur de mise en miroir respectif.

**7.** Circuit selon l'une quelconque des revendications précédentes, dans lequel ledit étage de rétroaction (8) comprend un diviseur conçu pour générer ladite tension de rétroaction ($V_R$) en tant que division de ladite tension de sortie ($V_{out}$).

**8.** Circuit selon l'une quelconque des revendications précédentes, dans lequel ledit étage d'amplification de sortie (8) comprend : un premier transistor de sortie ($M_{n1}$) qui est connecté entre un nœud interne (N) et une borne de potentiel de référence et dont la borne de commande est reliée à ladite première entrée (6a) ; un deuxième transistor de sortie ($M_{n1}$) qui est connecté entre ladite sortie (6c) et ladite borne de potentiel de référence et dont la borne de commande est reliée à ladite deuxième entrée (6b) ; et un miroir de courant (14) qui est alimenté par une tension d'alimentation (VCP) et qui comporte une première branche de mise en miroir et une deuxième branche de mise en miroir, qui sont reliées respectivement audit nœud interne (N) et à ladite sortie (6c).

**9.** Circuit selon l'une quelconque des revendications précédentes, dans lequel ledit premier amplificateur opérationnel (10) et ledit deuxième amplificateur opérationnel (11) sont des amplificateurs de transconductance du type pleinement symétrique.

**10.** Dispositif convertisseur numérique-analogique (1) comprenant :

le circuit amplificateur (20) selon l'une quelconque des revendications précédentes ;
un étage de conversion d'entrée (2) conçu pour recevoir un signal numérique ($S_{in}$) et pour générer ladite tension d'entrée ($V_L$) pour ledit circuit amplificateur (20) ; et
un étage formant pompe de charge (9), conçu pour générer une tension d'alimentation ($V_{CP}$), ayant une valeur augmentée par rapport à une tension d'entrée ($V_{DD}$), pour l'étage d'amplification de sortie (6) dudit circuit amplificateur (20).

**11.** Mémoire non volatile (40) comprenant une matrice de cellules de mémoire (42) et le dispositif convertisseur numérique-analogique (1) selon la revendication 10, qui est conçu pour générer des tensions de polarisation pour lesdites cellules de mémoire (42).

**12.** Procédé de commande d'un circuit amplificateur (20), comprenant :

un étage d'amplification d'entrée (4) comprenant un premier amplificateur opérationnel (10) ayant une première entrée différentielle et une première sortie (4c) ; et comprenant en outre un deuxième amplificateur opérationnel (11) ayant une deuxième entrée différentielle et une deuxième sortie, dans lequel une entrée non inverseuse (4a) de la première entrée différentielle du premier amplificateur opérationnel est connectée à une entrée inverseuse de la deuxième entrée différentielle du deuxième amplificateur opérationnel et est conçue pour recevoir une tension d'entrée ($V_L$), et une entrée inverseuse (4b) de la première entrée différentielle du premier amplificateur opérationnel est connectée à une entrée non inverseuse de la deuxième entrée différentielle du deuxième amplificateur opérationnel et est conçue pour recevoir une tension de rétroaction ($V_R$);
un étage d'amplification de sortie (6), qui a une première entrée (6a) et une deuxième entrée (6b) qui sont connectées à une sortie respective des première et deuxième sorties (4c, 4d) des premier et deuxième amplificateurs opérationnels (10, 11) de l'étage d'amplification d'entrée (4) et est conçu pour fournir sur une sortie (6c) une tension de sortie ($V_{out}$) liée à la tension d'entrée ($V_L$) par un facteur d'amplification ($\beta$) ; et
un étage de rétroaction (8), qui est relié à la sortie (6c) de l'étage d'amplification de sortie (6) et est conçu pour générer la tension de rétroaction ($V_R$) en fonction de la tension de sortie ($V_{out}$), **caractérisé en ce qu'**il comprend : la mise en œuvre avec un étage de commande en mode commun (22), qui est connecté aux première et deuxième sorties (4c, 4d) des premier et deuxième amplificateurs opérationnels (10, 11) de l'étage d'amplification d'entrée (4), d'une comparaison d'une première tension différentielle ($V_1$) et respectivement d'une deuxième tension différentielle ($V_2$) qui sont présentes sur les première et deuxième sorties (4c, 4d) des premier et deuxième amplificateurs opérationnels (10, 11) de l'étage d'amplification d'entrée (4), avec une tension de référence ($V_{CMref}$) ; et le forçage d'un courant de régulation respectif ($I_1$, $I_2$) d'un premier et un deuxième générateur de courant (24, 25) qui sont connectés à une entrée respective des première et deuxième entrées (6a, 6b) de l'étage d'amplification de sortie (6), avec une valeur de courant de régulation qui est fonction d'un résultat de la comparaison respective, afin de compenser une augmentation simultanée de ladite première tension différentielle ($V_1$) et de ladite deuxième tension différentielle ($V_2$).

13. Procédé selon la revendication 12, dans lequel l'étape de forçage du courant de régulation comprend la génération, en fonction de ladite comparaison, d'un premier signal de commande ($S_1$) et d'un deuxième signal de commande ($S_2$) pour commander respectivement le premier générateur de courant (24) et le deuxième générateur de courant (25), pour la génération desdits courants de régulation ($I_1$, $I_2$).

1

$V_{out}$

8a

8

8b

6c

OUTPUT AMPLIFICATION STAGE

6

$V_{CP}$

3

9

CHARGE PUMP

$V_{DD}$

6a

4c

INPUT AMPLIFICATION STAGE

4

6b

4d

$V_L$

4a

$V_R$

4b

$V_{DD}$

CONVERTER STAGE

2

$S_{in}$

$V_{BG}$

FIG. 1

FIG. 2

EP 3 107 210 B1

FIG. 3

FIG. 9

FIG. 4

FIG. 5

FIG. 6

FIG. 7

FIG. 8A

FIG. 8B

**EP 3 107 210 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6433521 B1
- US 2006197513 A1